# DEMANDE DE BREVET EUROPEEN

(11) **EP 0 998 038 A1**
(43) Date de publication de la demande: **03.05.2000**
(21) Numéro de dépôt: 99402627.6
(22) Date de dépôt: 22.10.1999
(51) Int. Cl.: H03H 9/05

(54) **Module de composants superposés dans un même boîtier**

(30) Priorité: 30.10.1998 FR 9813666
(71) Demandeur: THOMSON-CSF, 75008 Paris (FR)
(72) Inventeur: Wright, Peter, Thomson-CSF PI, Départ. des Brevets, 94117 Arcueil Cedex (FR)

(57) **Abrégé**

L'invention concerne un module de composants comprenant un boîtier d'encapsulation à l'intérieur duquel sont superposés des composants dont au moins un, est un dispositif à ondes de surface (DOS). Les composants sont réalisés à la surface de substrats, pouvant être empilés les uns sur les autres, par l'intermédiaire de matériaux liants. Ces substrats peuvent également être fixés sur des marches définies au niveau des faces internes du boîtier d'encapsulation. Ces configurations permettent une meilleure compacité et donc un coût plus faible des composants encapsulés.

Application : Filtre à ondes de surface.

## Description

Le domaine de l'invention est celui des composants encapsulés et plus particulièrement celui des dispositifs à ondes de surface (DOS).

Actuellement, le marché de la téléphonie mobile exige des appareils toujours plus petits et toujours moins chers. La tendance est aux téléphones portables multi-standards et/ou multi-bandes, ce qui requiert l'utilisation de plusieurs filtres spécifiques.

Par ailleurs, les filtres sont souvent associés à d'autres composants de manière à adapter leurs niveaux d'impédance à ceux du circuit. Ces composants associés posent généralement un problème d'encombrement ; ils consomment une place précieuse dans le circuit alors que la taille des filtres est déterminante en terme de coût. En effet, ils sont généralement disposés dans un même plan que celui du DOS associé, le boîtier d'encapsulation de l'ensemble de ces composants doit alors être suffisamment grand. Aujourd'hui il s'agit de boîtier en céramique, matériau particulièrement onéreux, c'est pourquoi l'invention propose une solution pour rendre plus compact l'ensemble des composants associés aux DOS.

En effet, l'invention propose de superposer plusieurs DOS et/ou autres composants à l'intérieur d'un même boîtier.

Plus précisément, l'invention a pour objet un module de composants comprenant un boîtier d'encapsulation et un ensemble d'au moins deux composants, l'un de ces composants étant un dispositif à ondes acoustiques de surface, caractérisé en ce que les composants sont empilés à l'intérieur du boîtier d'encapsulation, l'ensemble des composants empilés comprenant des connexions électriques, le boîtier d'encapsulation comportant des plots électriques extérieurs et des moyens de contact électrique pour connecter lesdites connexions électriques auxdits plots électriques.

Avantageusement, le module de composants selon l'invention peut comprendre au moins un substrat supportant un composant sur chacune de ses faces parallèles au plan du boîtier.

Selon une variante de l'invention, les composants peuvent être fixés individuellement aux faces internes du boîtier d'encapsulation.

Ainsi, selon une variante préférentielle de l'invention, le module de composants comprend M composants, le boîtier d'encapsulation comportant un volume d'évidement constitué de N volumes élémentaires empilés, de section croissante, de manière à définir des profils d'évidement en escalier, l'ensemble des composants étant soutenu par l'ensemble des marches des escaliers, M étant supérieur ou égal à N et chaque volume élémentaire comportant au moins un composant.

De préférence, les composants sont à la surface de substrats, lesdits substrats reposant sur les marches définies dans le boîtier.

Selon une autre variante de l'invention, les composants peuvent être empilés les uns sur les autres par l'intermédiaire de couches de matériau liant.

Selon une variante de l'invention, les moyens de contact électrique comprennent des fils électriques reliant les composants à des métallisations réalisées sur les faces internes du boîtier d'encapsulation.

Selon une variante de l'invention, les moyens de contact électrique comprennent des plots électriques internes, assurant la liaison électrique entre les composants et des métallisations réalisées sur les faces internes du boîtier d'encapsulation.

L'invention sera mieux comprise et d'autres avantages apparaîtront à la lecture de la description qui va suivre, donnée à titre non limitatif et grâce aux figures annexées parmi lesquelles :
- la figure 1 illustre un premier exemple de module de composants selon l'invention comprenant un substrat porteur de composants sur chacune de ses faces ;
- la figure 2 illustre un deuxième exemple de module de composants selon l'invention comprenant deux substrats fixés indépendamment à l'intérieur du boîtier et des connexions électriques de type fils ;
- la figure 3 illustre un troisième exemple de module de composants selon l'invention comprenant deux substrats fixés indépendamment à l'intérieur du boîtier et des connexions électriques de type point ;
- la figure 4 illustre un quatrième exemple de module de composants selon l'invention comprenant deux substrats empilés l'un sur l'autre par l'intermédiaire d'un matériau liant ;
- la figure 5 illustre un cinquième exemple de module de composants selon l'invention comprenant des substrats indépendants, chaque substrat supportant plusieurs composants sur deux faces opposées ;
- la figure 6 illustre un sixième exemple de module de composants selon l'invention, dans lequel des composants sur un premier substrat sont directement associés à un DOS supporté par un second substrat.

De manière générale, l'invention propose d'empiler des DOS entre eux avec d'autres composants tels que des inductances ou des capacités.

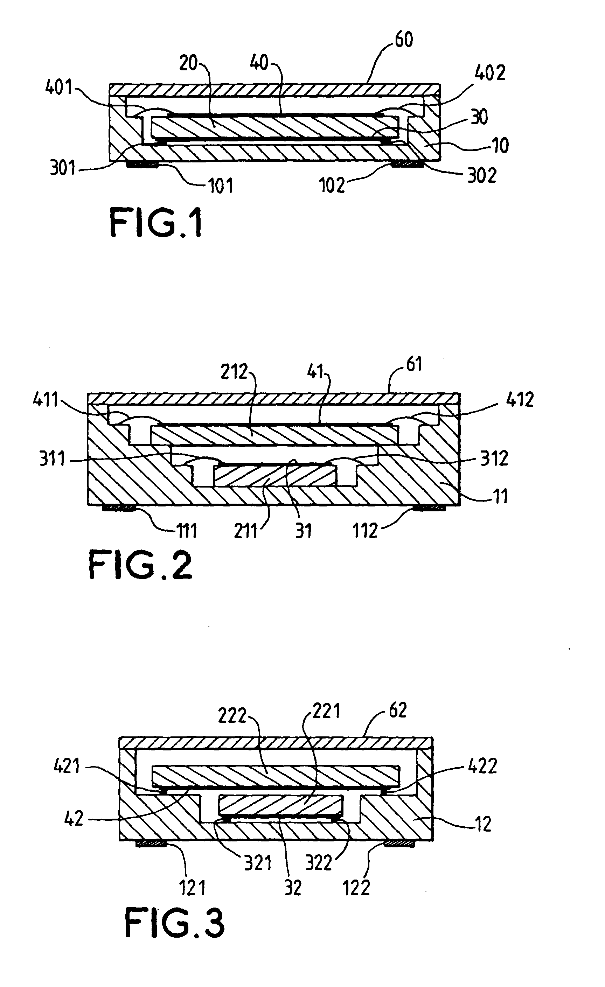

Une méthode directe et avantageuse en terme de coût, consiste à utiliser un unique substrat porteur de part et d'autre d'un DOS et d'un second composant comme l'illustre la figure 1. Selon cette configuration dans laquelle M = N = 2, un boîtier d'encapsulation 10 comporte un unique substrat piézoélectrique 20, sur lequel sont réalisés les deux composants, pouvant être deux DOS 30 et 40. Des connexions électriques 401 et 402 de type fils électriques relient le DOS supérieur 40 à des métallisations réalisées au niveau du boîtier. Le DOS inférieur 30 est relié à des métallisations du boîtier par des contacts 301 et 302 de type « flip chip » (technique de la puce retournée, connue de l'homme de l'art). Des plots électriques 101 et 102 permettent de connecter l'ensemble des composants inclus dans le boîtier, à des circuits extérieurs par des métallisations internes et des vias dans la céramique de manière classique, l'ensemble étant fermé par un couvercle 60.

Selon l'art connu, les plots électriques 101 et 102 comportent le nombre de broches adéquat pour connecter indépendamment les composants du boîtier avec des circuits extérieurs.

Ce mode de réalisation n'entraîne qu'un très léger accroissement de l'épaisseur du boîtier par rapport à celle d'un boîtier de l'art connu comprenant un seul DOS. De plus, cette nouvelle architecture requiert moins de substrat que ne l'exigeait l'art antérieur pour réaliser deux DOS.

Par ailleurs, dans la mesure où les téléphones mobiles ne fonctionnent pas simultanément sur deux bandes de fréquences ou sur deux standards, simultanément, les interférences acoustiques ou électriques entre les deux DOS est sans importance.

Néanmoins, dans certains cas, et notamment dans le cas de DOS à ondes de surface transversales, la surface opposée du substrat porteur du DOS doit être irrégulière afin d'éviter les réflexions des ondes acoustiques de volume qui viendraient interférer avec la réponse désirée du dispositif. Il peut typiquement s'agir d'une surface non polie.

Une configuration pour surmonter ce problème est illustré en figure 2. On utilise deux DOS ou filtres séparés, chacun supporté par un substrat reposant sur les marches définies dans le boîtier d'encapsulation. Deux substrats piézoélectriques 211 et 212 supportent deux DOS 31 et 41. Le premier substrat repose sur la face interne du boîtier d'encapsulation 11, le DOS 31 réalisé à la surface de ce premier substrat est connecté électriquement par l'intermédiaire de fils 311 et 312 à des métallisations réalisées dans le même plan que le DOS 31 et ce sur des marches définies dans la face interne du boîtier d'encapsulation pour lequel N = 4 avec M = 2. Le second substrat piézoélectrique 212 est fixé sur d'autres marches définies dans le boîtier d'encapsulation et est également connecté électriquement par l'intermédiaire de fils électriques 411 et 412 à des métallisations réalisées dans un même plan que le plan du DOS 41. Un couvercle d'encapsulation 61 isole l'ensemble des composants de l'extérieur. Deux plots de connexion 111 et 211 assurent le contact électrique des composants avec l'extérieur.

Le module de composants illustré en figure 2 peut également comprendre selon la même architecture un substrat piézoélectrique sur lequel est réalisé un DOS et un substrat de type verre ou céramique portant des composants associés au DOS montés ou imprimés sur ledit substrat.

Nous venons de décrire un exemple de module de composants selon l'invention dans lequel deux composants sont réalisés à la surface de deux substrats.

La figure 3 illustre une seconde configuration reprenant les mêmes contraintes en terme de substrats indépendants. Dans cette configuration, les connexions électriques sont de type « flip chip ». Les composants 32 et 42 sont au niveau des faces inférieures des substrats 221 et 222 et des connexions de type point, respectivement 321 et 322, 421 et 422, le boîtier étant fermé par un couvercle 62. L'avantage de cette disposition est de réduire le profil du boîtier d'encapsulation par rapport à celle illustrée en figure 2, ainsi N est réduit à 2 et M = 2.

Selon d'autres variantes de l'invention, il est possible d'utiliser une combinaison de connexions de type fils et des connexions de type point et conduisant à une configuration dans laquelle M = N.

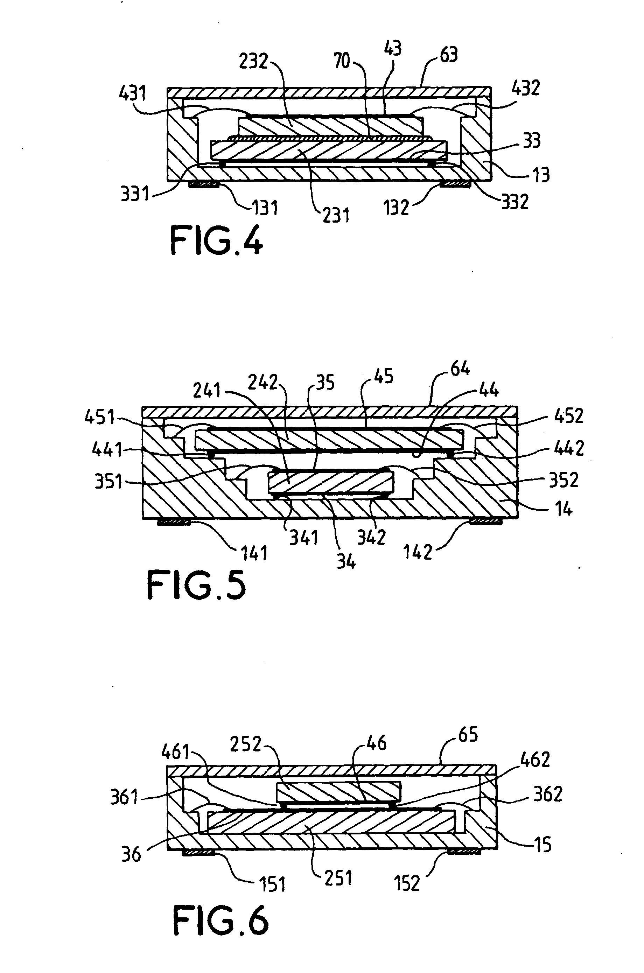

Notamment, dans l'exemple de module de composants illustrés en figure 4, une telle combinaison est intégrée dans le boîtier d'encapsulation 13. De plus, dans cette configuration deux substrats 231 et 232 sont empilés par l'intermédiaire d'une couche de matériau liant 70. Les deux substrats 231 et 232 comportent respectivement un composant 33 en face inférieure et 43 en face supérieure. Le composant 33 est relié par des connexions 331 et 332 de type « flip chip » à des contacts électriques du boîtier non représentés. Le composant 43 est relié par des connexions de type fils 431 et 432 à des métallisations du boîtier. Le matériau liant 70 peut être ou non conducteur électrique. L'ensemble est fermé par un couvercle 63.

Lorsque le matériau liant est conducteur, il est de préférence relié à la masse. Cette configuration est particulièrement intéressante pour utiliser simultanément deux filtres par exemple dans le cas de filtres connectés en cascade. Selon d'autres variantes, le matériau liant peut être choisi pour d'autres propriétés, telles qu'une meilleure absorption des ondes de volume.

Dans les deux cas, le matériau liant peut être utilisé pour absorber l'énergie des ondes acoustiques de volume dans chaque substrat supprimant ainsi les réponses indésirables des fonctions de transfert des composants lorsque ceux-ci sont de type filtre.

Selon les exemples précédents de modules de composants, il est possible d'utiliser un même substrat porteur de composants sur chacune de ses faces opposées ou bien des composants supportés par des substrats indépendants.

L'invention porte également sur des configurations mixtes dans lesquelles plusieurs substrats indépendants sont fixés au boîtier d'encapsulation, chaque substrat supportant sur ses faces opposées plusieurs composants.

Plus précisément, selon l'exemple illustré en figure 5 dans lequel M = N = 4, deux substrats 241 et 242 supportent chacun deux composants. Plus précisément, le substrat inférieur 241 comporte deux composants 34 et 35 respectivement connectés électriquement aux plots 141 et 142 du boîtier 14 par des contacts électriques 341, 342 et 351 et 352. Le substrat supérieur 242 comporte deux composants 44 et 45 respectivement connectés électriquement aux plots 141 et 142 du boîtier 14, par des contacts 441, 442 et 451 et 452, l'ensemble étant fermé par un couvercle 64. Cette configuration permet de définir des connexions électriques sur chaque face métallisée.

Dans le domaine des filtres à ondes de surface, il peut être nécessaire d'associer des composants en série au filtre, de manière à adapter leur niveau d'impédance à celui d'un circuit extérieur. Le module de composants selon l'invention permet ce type d'association de composants dans un encombrement minimal. La figure 6 illustre à cet égard un exemple de module de composants dans lequel un boîtier d'encapsulation 15 comprend un premier substrat 251 sur lequel sont réalisés des composants tels que des inductances ou des capacités 36, ce substrat peut être un substrat silicium contenant des composants ou un substrat tel que le verre ou la céramique portant des composants et où M = N = 2. Un second substrat 252 comprend un composant de type DOS 46 relié aux composants précédents par la technique de connexions de type points par deux points conducteurs 451 et 452, les premiers composants 36 étant connectés électriquement par des fils 351 et 352 à des métallisations du boîtier d'encapsulation. Le boîtier d'encapsulation 15 comprend de manière constante des plots conducteurs 151 et 152 pour assurer la connexion électrique avec l'extérieur des différents composants.

Tous les exemples décrits précédemment, l'ont été avec deux substrats pour simplifier les détails de description, néanmoins, le module de composants peut comprendre N substrats avec M composants, M pouvant être supérieur à N dans le cas de substrat porteur de composants sur deux faces, correspondant à une généralisation de l'exemple illustré en figure 5.

## Revendications

1. Module de composants comprenant un boîtier d'encapsulation (10,11,12,13,14,15) et un ensemble d'au moins deux composants (30,40,31,41,32,42,33,43,34,35,44,45,36,46) l'un de ces composants étant un dispositif à ondes acoustiques de surface, caractérisé en ce que les composants sont empilés à l'intérieur du boîtier d'encapsulation, l'ensemble des composants empilés comprenant des connexions électriques, le boîtier d'encapsulation comportant des plots électriques extérieurs (101,102,111, 112,121,122,131,132,141,142,151,152) et des moyens de contact électrique (301,302,401,402,311,312,411,412,321,322,421,422,331,332,431,432,341, 342,441,442,351,352,451,452,361,362) pour connecter lesdites connexions électriques auxdits plots électriques.

2. Module de composants selon la revendication 1, caractérisé en ce qu'il comprend au moins un substrat, ledit substrat supportant un composant sur chacune de ses faces parallèles au plan du boîtier.

3. Module de composants selon l'une des revendications 1 ou 2, caractérisé en ce que le boîtier comprend des moyens de fixation pour fixer l'ensemble des composants à la face interne du boîtier.

4. Module de composants selon la revendication 2, caractérisé en ce qu'il comprend M composants, le boîtier d'encapsulation comportant un volume d'évidement constitué de N volumes élémentaires empilés, de section croissante, de manière à définir des profils d'évidement en escalier, l'ensemble des composants étant soutenu par l'ensemble des marches des escaliers, M étant supérieur ou égal à N et chaque volume élémentaire comportant au moins un composant.

5. Module de composants selon la revendication 4, caractérisé en ce que les composants sont à la surface de substrats, lesdits substrats reposant sur les marches définies dans le boîtier.

6. Module de composants selon l'une des revendications 1 à 4, caractérisé en ce que les moyens de contact électrique comprennent des fils électriques reliant les composants à des métallisations réalisées sur les marches des escaliers définis dans le boîtier.

7. Module de composants selon l'une des revendications 1 à 5, caractérisé en ce que les moyens de contact électrique comprennent des points de contacts électriques.
